# EUROPÄISCHE PATENTSCHRIFT

(11) **EP 0 747 713 B1**
(45) Veröffentlichungstag und Bekanntmachung des Hinweises auf die Patenterteilung: **12.07.2006**
(21) Anmeldenummer: 96108434.0
(22) Anmeldetag: 28.05.1996
(51) Int. Cl.: G01R 19/00, G01R 17/02, G05F 3/16, G01R 31/26

(54) **Schaltungsanordnung zum Erfassen des Laststroms eines Leistungshalbleiterbauelementes mit source- oder drainseitiger Last**
Circuit for measuring the load current of a power semiconductor device with a load on the source or drain side
Circuit capteur de courant de charge d'un composant semi-conducteur de puissance avec charge soit à la borne de source ou soit à la borne de drain

(30) Priorität: 07.06.1995 DE 19520735
(43) Veröffentlichungstag der Anmeldung: 11.12.1996
(73) Patentinhaber: Infineon Technologies AG, 81669 München (DE)
(72) Erfinder: Tihanyi, Jenö, Dr. Ing., 85551 Kirchheim (DE); Koroncai, Adam-Istvan, Dipl.-Ing., 9020 Klagenfurt (AT)
(74) Vertreter: Patentanwälte Westphal, Mussgnug & Partner

(56) Entgegenhaltungen:
- EP-A- 0 227 149
- EP-A- 0 274 995
- EP-A- 0 438 363
- FR-A- 2 642 176

## Beschreibung

Die Erfindung bezieht sich auf eine Schaltungsanordnung zum Erfassen des Laststroms eines durch Feldeffekt steuerbaren Leistungs-Halbleiterbauelements, mit den Merkmalen:
- einem weiteren durch Feldeffekt steuerbaren Halbleiterbauelement,
- die Drainanschlüsse und Gateanschlüsse beider Halbleiterbauelemente sind jeweils miteinander verbunden,
- durch das weitere Halbleiterbauelement fließt ein Bruchteil des Laststroms,
- einem dem weiteren Halbleiterbauelement in Reihe geschalteten Widerstand, an dem eine dem Laststrom proportionale Spannung abgreifbar ist.

Eine solche Schaltungsanordnung ist z.B. in dem Artikel "Surviving Short Circuits" von R.Frank und A.Pshaenich, Machine Design, March 8, 1990, Seiten 89 bis 96 beschrieben worden. In diesem Artikel ist das Prinzip dargestellt, daß der Laststrom eines Leistungs-MOSFET dadurch erfaßt werden kann, daß dem Leistungs-MOSFET ein ähnlicher, von der Fläche her kleinerer MOSFET parallel geschaltet und diesem kleineren MOSFET, dem sogenannten "Sense"-FET, sourceseitig ein Meßwiderstand in Reihe geschaltet wird. Ist der Leistungs-FET drainseitig mit einer Last verbunden, so fließt durch den weiteren FET ein Strom, der dem Laststrom etwa proportional ist. Der Proportionalitätsfaktor hängt dabei vom Verhältnis der stromführenden Flächen des Sense-FET zu der des Leistungs-FET ab. Fließt durch die Last und damit durch den Leistungs-FET ein Laststrom, so fließt damit ein dem Laststrom etwa proportionaler Teil durch den Sense-FET und den Meßwiderstand. Am Meßwiderstand kann dann eine dem Laststrom etwa proportionale Spannung abgegriffen werden.

Voraussetzung ist dabei, dass der Messwiderstand auf die Last abgestimmt ist. Bei einer anderen Last muss daher entweder der Messwiderstand geändert werden oder die die Spannung erfassende Auswertelogik.

Die US-Patentschrift US 4,885,477 beschreibt eine Schaltungsanordnung mit einem Leistungs-MOSFET und einem Sense-FET, bei dem in Serie zum Messwiderstand ein weiterer MOSFET, welcher als steuerbarer Widerstand dient, geschalten ist. Dieser weitere MOSFET wird von einem Differenzverstärker derart angesteuert, dass die Drain-Sourcespannung des Sense-FET und die Drain-Sourcespannung des Leistungs-MOSFET annähernd gleiche Werte annehmen. Durch die Offset-Spannung des Differenzverstärkers entsteht ein Regelfehler und es bleibt eine gewisse Differenz zwischen den Drain-Sourcespannungen von Sense-FET und Leistungs-MOSFET. Eine ähnliche Schaltung ist in EP 0 227 149 offenbart.

Der Erfindung liegt die Aufgabe zugrunde, eine Schaltung der erwähnten Gattung so weiterzubilden, dass dieser Regelfehler reduziert wird. Außerdem soll sie für den meist vorkommenden Fall des High-Side-Schalters verwendbar sein.

Diese Aufgabe wird durch eine Schaltungsanordnung gemäß Patentanspruch 1 gelöst, vorteilhafte Weiterentwicklungen finden sich in den Unteransprüchen.
Der Widerstand ist einerseits mit einem auf festem Potential liegenden Anschluss verbunden und andererseits über einen steuerbaren Widerstand mit dem Sourceanschluss des weiteren Halbleiterbauelementes verbunden und der Strom des weiteren Halbleiterbauelementes wird durch den steuerbaren Widerstand derart eingestellt wird, dass die Drain-Sourcespannungen beider Halbleiterbauelemente einander gleich sind.

Wird die Schaltungsanordnung nicht mit Leistungs-MOSFET sondern mit IGBT betrieben, so ist der Begriff "Source" durch "Emitter" zu ersetzen.

Die Erfindung wird in Verbindung mit den Figuren 1 bis 3 näher erläutert. Es zeigen:
- Figur 1: den prinzipiellen Aufbau der Schaltungsanordnung,
- Figur 2: eine erweiterte Schaltungsanordnung gemäß der Erfindung und
- Figur 3: eine Anordnung, die gegenüber der nach Figur 1 durch verschiedene Komponenten ergänzt ist.

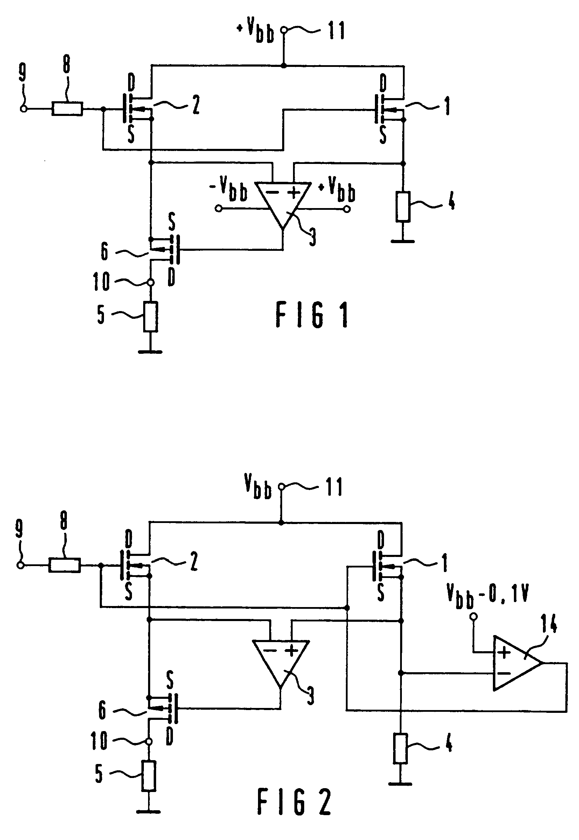

Die Schaltung nach Figur 1 enthält einen Leistungs-MOSFET 1, dem sourceseitig eine Last 4 in Reihe geschaltet ist. Er stellt damit einen High-Side-Schalter dar. Die Schaltung enthält außerdem einen weiteren MOSFET 2. Dieser bildet den erwähnten Sense-FET und ist im allgemeinen durch einige Zellen des Leistungs-MOSFET 1 gebildet. Er kann z.B. 10 Zellen umfassen, während der Leistungs-MOSFET 1 10000 Zellen hat. Die Drainanschlüsse D beider MOSFET sind miteinander verbunden, ebenso ihre Gateanschlüsse. Ihre Sourceanschlüsse sind getrennt. Mit dem Sourceanschluß des MOSFET 2 ist ein steuerbarer Widerstand 6 angeschlossen. Der steuerbare Widerstand ist andererseits über einen Anschluß 10 mit einem Meßwiderstand 5 verbunden. Der andere Anschluß des Meßwiderstandes 5 liegt an einem festen Potential, vorzugsweise an Masse. Diese Masse kann, muß jedoch jedoch nicht derjenigen identisch sein, an der die Last 4 liegt.

Der steuerbare Widerstand 6 ist zweckmäßigerweise als MOSFET ausgebildet. Dann ist sein Sourceanschluß mit dem Meßwiderstand 5 verbunden und sein Drainanschluß mit dem Sourceanschluß des MOSFET 2. Er ist vom umgekehrten Kanaltyp wie der MOSFET 2. Der Gateanschluß des MOSFET 6 ist mit dem Ausgang eines Differenzverstärkers 3 verbunden. Dieser hat zwei Eingänge, von denen der negative Eingang mit dem Sourceanschluß des MOSFET 2 und der positive Eingang mit dem Sourceanschluß des Leistungs-MOSFET 1 verbunden ist.

Die gesamte Anordnung liegt an einer Betriebsspannung +V_{bb}, die zwischen einem Anschluß 11 und Masse angelegt wird. Der Anschluß 11 ist mit den Drainanschlüssen der MOSFET 1 und 2 verbunden. Die Gateanschlüsse beider MOSFET sind über einen Widerstand 8 mit einem Eingang 9 verbunden, an den, z.B. über eine Pumpschaltung eine Steuerspannung angelegt werden kann.

Wird eine Steuerspannung am Eingang 9 angelegt, so wird der Leistungs-MOSFET 1 und der weitere MOSFET 2 leitend gesteuert. Es fließt ein Laststrom durch die Last 4. Durch den MOSFET 2, den steuerbaren Widerstand 6 und den Meßwiderstand 5 fließt ebenfalls ein Strom. An den Sourceanschlüssen der MOSFET 1 und 2 stellt sich jeweils eine Spannung ein, die am negativen bzw. positiven Eingang des Differenzverstärkers 3 anliegt. Abhängig von der Differenz dieser Spannungen tritt am Ausgang von 3 eine Spannung auf, die den MOSFET 6 steuert.

Es sei zunächst angenommen, daß die Source-Drainspannung am MOSFET 2 größer ist als die am MOSFET 1. Dann tritt am Eingang des Differenzverstärkers 3 eine Spannung auf, die den MOSFET 6 in einen Bereich höheren Widerstandes steuert. Der Strom durch den MOSFET 2 wird dadurch verringert, wodurch seine Drain-Sourcespannung steigt. Der Strom durch den MOSFET 2 wird nun so lange geregelt, bis die Differenz der Eingangsspannungen Null ist, d.h. bis die Drain-Sourcespannungen der MOSFET 1 und 2 gleich sind. Das bedeutet, daß im eingeregelten, stationären Zustand durch den Meßwiderstand 5 ein Strom fließt, der dem Laststrom unabhängig von der Größe der Last 4 immer fest proportional ist. Ändert sich also im Lauf des Betriebes die Last 4 z.B. durch einen teilweisen Kurzschluß oder durch den Ausfall einiger parallelgeschalteter Lasten, so erhöht bzw. verringert sich die Drain-Sourcespannung am Leistungs-MOSFET 1 und damit wird der veränderbare Widerstand 6 in Richtung geringeren bzw. höheren Widerstandes gesteuert, bis die Spannungsdifferenz am Eingang des Verstärkers 3 Null ist.

Voraussetzung für die feste Proportionalität ist, daß die I_{D}/U_{DS}-Kennlinien der MOSFET 1 und 2 einander ähnlich sind. D.h., daß für jeden Spannungswert U_{DS} durch den weiteren FET 2 ein Strom fließt, der einem festen Bruchteil des Laststroms beträgt. Dieser Strom erzeugt am Widerstand 5 eine auf Masse bezogene, dem Laststrom proportionale Spannung, die am Anschluß 10 abgegriffen werden kann. Die Ähnlichkeit läßt sich ohne weiteres dadurch erzielen, daß, wie eingangs erwähnt, der MOSFET 2 durch einige Zellen des Leistungs-MOSFET 1 gebildet ist. Das Verhältnis kann z.B. 10:10000 sein.

Sind die Kennlinien einander nicht ähnlich, tritt ein vom Laststrom abhängiger Regelfehler auf.

Die erfindungsgemäße Schaltungsanordnung nach Figur 2 unterscheidet sich von der nach Figur 1 durch einen zusätzlichen Differenzverstärker 14, dessen erster Eingang mit dem Sourceanschluß des Leistungs-MOSFET 1 verbunden ist. Am anderen Eingang des Differenzverstärkers 14 liegt eine feste Spannung an. Der Ausgang von 14 ist mit den Gateanschlüssen der MOSFET 1 und 2 verbunden. Der zusätzliche Differenzverstärker 14 hat den Zweck, die Drain-Sourcespannung des MOSFET 1 auf einen Wert einzustellen, der höher ist als die Offset-Spannung des Differenzverstärkers 3. Beträgt die Offset-Spannung z.B. 5 mV, so kann die am zweiten Eingang des Verstärkers 14 liegende Spannung z.B. V_{bb}-0,1 V sein. Damit wird die Drain-Sourcespannung des MOSFET auf 0,1 V eingestellt. Bei der erwähnten Größe der Offset-Spannung beträgt der Regelfehler dann nur 5/100 mV = 5%. Die Erhöhung der Drain-Sourcespannung am MOSFET 1 um z.B. 0,1 V erhöht den Durchlaßwiderstand des Leistungs-MOSFET nur unerheblich. Damit ist die Erhöhung der Verluste im Leistungs-MOSFET 1 vernachlässigbar gering.

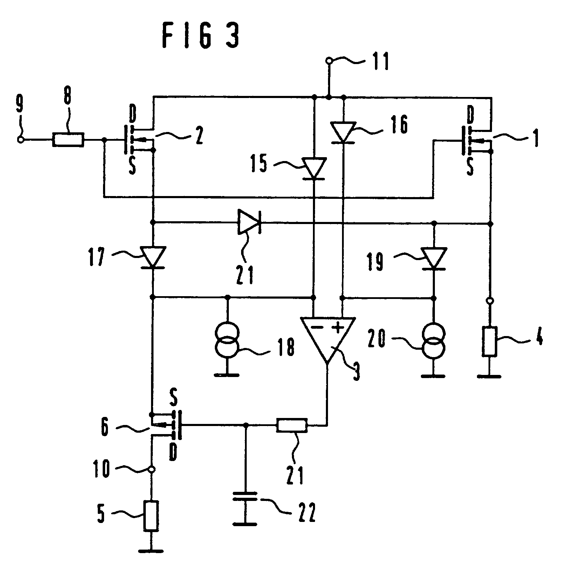

Das Ausführungsbeispiel nach Figur 3 ist gegenüber dem nach Figur 1 um einige Bauteile ergänzt. So ist der negative Eingang des Verstärkers 3 über eine Diode 15 mit dem Anschluß 11 und über eine Stromquelle 18 mit Masse verbunden. Der andere Ausgang ist über eine Diode 16 mit dem Anschluß 11 und über eine Stromquelle 20 mit Masse verbunden. Der negative Eingang ist außerdem über eine Diode 17 mit dem Sourceanschluß des MOSFET 2 verbunden, der positive Eingang über eine Diode 19 mit dem Sourceanschluß des Leistungs-MOSFET 1. Die Dioden und Stromquellen dienen dazu, dem Verstärker 3 den richtigen Arbeitspunkt einzustellen. Alle Dioden können als MOS-Dioden ausgeführt sein, die Stromquellen können als Stromspiegelschaltung oder als Depletion-MOSFET realisiert werden.

Zwischen dem Ausgang des Verstärkers 3 und dem Gateanschluß des MOSFET 6 kann ein Widerstand 21 angeschlossen sein, dessen mit dem Gateanschluß von 6 verbundener Anschluß mit einem Kondensator 22 verbunden ist. Der andere Anschluß des Kondensators liegt auf Masse. Diese RC-Kombination wirkt der Schwingneigung des Verstärkers 3 entgegen. Der Verstärker 3 ist zweckmäßigerweise ein Operationsverstärker.

Die erfindungsgemäße Schaltung läßt sich im wesentlichen temperaturunabhängig betreiben, wenn der Meßwiderstand 5 selbst temperaturunabhängig oder wenig temperaturabhängig ist. Dies kann z.B. dadurch erreicht werden, daß der Meßwiderstand 5 aus Polysilizium besteht oder als temperaturkompensierter Widerstand ausgeführt ist.

Die Schaltung wurde anhand eines High-Side-Schalters erläutert. Sie ist jedoch auch für einen Low-Side-Schalter anwendbar. Hier befindet sich die Last 4 auf der Drainseite der beiden MOSFET, während der steuerbare Schalter 6 und der Meßwiderstand 5 auf der Sourceseite des MOSFET 2 angeschlossen bleibt.

## Patentansprüche

1. Schaltungsanordnung zum Erfassen des Laststromes eines durch Feldeffekt steuerbaren Leistungs-Halbleiterbauelements (1), mit den Merkmalen:
- einem weiteren durch Feldeffekt steuerbaren Halbleiterbauelement (2),
- die Drainanschlüsse und Gateanschlüsse beider Halbleiterbauelemente sind jeweils miteinander verbunden,
- durch das weitere Hableiterbauelement fliesst ein Bruchteil des Laststroms,
- einem dem weiteren Halbleiterbauelement in Reihe geschalteten Widerstand (5), an dem eine dem Laststrom proportionale Spannung abgreifbar ist,
wobei
- der Widerstand (5) einerseits mit einem auf festem Potential liegenden Anschluss verbunden ist und andererseits über einen steuerbaren Widerstand (6) mit dem Sourceanschluss des weiteren Halbleiterbauelements (2), und wobei
- der Strom des weiteren Halbleiterbauelementes (2) durch den steuerbaren Widerstand (6) derart eingestellt wird, dass die Drain-Sourcespannungen beider Halbleiterbauelemente (1, 2) einander gleich sind, und wobei
- der steuerbare Widerstand (6) ein MOSFET ist, dessen Steuereingang mit dem Ausgang eines ersten Differenzverstärkers (3) verbunden ist, dessen erster Eingang mit dem Sourceanschluss des Leistungs-Halbleiterbauelements (1) und dessen zweiter Eingang mit dem Sourceanschluss des weiteren Halbleiterbauelements (2) verbunden ist,
**dadurch gekennzeichnet, dass** der Sourceanschluss des Leistungs-Halbleiterbauelements (1) mit dem ersten Eingang eines zweiten Differenzverstärkers (14) verbunden ist, an dessen zweitem Eingang eine Spannung anlegbar ist, die größer ist als die Offset-Spannung des ersten Differenzverstärkers (3).

2. Schaltungsanordnung nach Anspruch 1,
**dadurch gekennzeichnet, dass** der Differenzverstärker (3) ein Operationsverstärker ist.

3. Schaltungsanordnung nach Anspruch 1,
**dadurch gekennzeichnet, dass** das feste Potential Massepotential ist.

4. Schaltungsanordnung nach einem der Ansprüche 1 bis 3,
**dadurch gekennzeichnet, dass** die bei den Halbleiterbauelemente (1, 2) einander ähnliche ID/UDS-Kennlinien haben.

5. Schaltungsanordnung nach einem der Ansprüche 1 bis 4,
**dadurch gekennzeichnet, dass** das Leistungs-Halbleiterbauelement (1) und das weitere Halbleiterbauelement (2) aus einer Vielzahl von auf einem einzigen Chip integrierten Zellen besteht.

## Claims

1. Circuit arrangement for detecting the load current of a field-effect-controllable power semiconductor component (1) having the features:
- a further field-effect-controllable semiconductor component (2),
- the drain terminals and gate terminals of the two semiconductor components are in each case connected to one another,
- a fraction of the load current flows through the further semiconductor component,
- a resistor (5) connected in series with the further semiconductor component, at which resistor a voltage proportional to the load current can be tapped off,
- the resistor (5) being connected, on the one hand, to a terminal connected to a fixed potential and, on the other hand, via a controllable resistor (6), to the source terminal of the further semiconductor component (2), and
- the current of the further semiconductor component (2) being set by the controllable resistor (6) in such a way that the drain-source voltages of the two semiconductor components (1, 2) are identical to one another, and
- the controllable resistor (6) being a MOSFET, the control input of which is connected to the output of a first differential amplifier (3), the first input of which is connected to the source terminal of the power semiconductor component (1) and the second input of which is connected to the source terminal of the further semiconductor component (2),
**characterized in that** the source terminal of the power semiconductor component (1) is connected to the first input of a second differential amplifier (14), to the second input of which can be applied a voltage that is greater than the offset voltage of the first differential amplifier (3).

2. Circuit arrangement according to Claim 1,
**characterized in that** the differential amplifier (3) is an operational amplifier.

3. Circuit arrangement according to Claim 1,
**characterized in that** the fixed potential is earth potential.

4. Circuit arrangement according to one of Claims 1 to 3,
**characterized in that** the two semiconductor components (1, 2) have ID/UDS characteristic curves which are similar to one another.

5. Circuit arrangement according to one of Claims 1 to 4,
**characterized in that** the power semiconductor component (1) and the further semiconductor component (2) comprise a multiplicity of cells integrated on a single chip.

## Revendications

1. Circuit capteur de courant de charge d'un composant semi-conducteur de puissance commandable par effet de champ (1) avec les caractéristiques suivantes :
- un autre composant semi-conducteur commandable par effet de champ (2),
- les bornes de drain et les bornes de grille des deux composants semi-conducteurs sont respectivement reliées les unes aux autres,
- une fraction du courant de charge traverse l'autre composant semi-conducteur,
- une résistance (5) montée en série avec l'autre composant semi-conducteur sur laquelle on peut prélever une tension proportionnelle au courant de charge,
dans lequel
- la résistance (5) est d'une part reliée à une borne connectée à un potentiel fixe et d'autre part, par l'intermédiaire d'une résistance commandable (6), à la borne de source de l'autre composant semi-conducteur (2), et
- le courant de l'autre composant semi-conducteur (2) est réglé par la résistance commandable (6) de sorte que les tensions drain-source des deux composants semi-conducteurs (1, 2) sont identiques, et
- la résistance commandable (6) est un MOSFET dont l'entrée de commande est reliée à la sortie d'un premier amplificateur de différence (3), dont la première entrée est reliée à la borne de source du composant semi-conducteur de puissance (1) et la deuxième entrée à la borne de source de l'autre composant semi-conducteur de puissance (2),
**caractérisé en ce que**
la borne de source du composant semi-conducteur de puissance (1) est reliée à la première entrée d'un deuxième amplificateur de différence (14) dont la deuxième entrée subit une tension supérieure à la tension offset du premier amplificateur de différence (3).

2. Circuit selon la revendication 1,
**caractérisé en ce que**
l'amplificateur de différence (3) est un amplificateur d'opérations.

3. Circuit selon la revendication 1,
**caractérisé en ce que**
le potentiel fixe est un potentiel de masse.

4. Circuit selon l'une quelconque des revendications 1 à 3,
**caractérisé en ce que**
les deux composants semi-conducteurs (1, 2) présentent des lignes caractéristiques ID/UDS similaires.

5. Circuit selon l'une quelconque des revendications 1 à 4,
**caractérisé en ce que**
le composant semi-conducteur (1) et l'autre composant semi-conducteur (2) sont réalisés à partir d'une multitude de cellules intégrées dans une seule puce.
